# EUROPEAN PATENT APPLICATION

(11) **EP 1 739 748 A2**
(43) Date of publication of application: **03.01.2007**
(21) Application number: 06116230.1
(22) Date of filing: 28.06.2006
(51) Int. Cl.: H01L 23/552

(54) **Magnetic shielding of MRAM chips**

(30) Priority: 28.06.2005 US 168203
(71) Applicant: Infineon Technologies AG, 81669 München (DE); Altis Semiconductor, 91105 Corbeil Essonnes Cedex (FR)
(72) Inventor: Braun, Daniel, 75013, Paris (FR); Gogl, Dietmar, Essex Junction, VT 05452 (US)
(74) Representative: Viering, Jentschura & Partner

(57) **Abstract**

An apparatus comprising a magnetically shielded MRAM chip and a method of manufacturing the same. The apparatus includes an MRAM module (201) and a protective cover (206). The MRAM module includes a circuit board (200) and a memory chip (204) attached to the circuit board, the memory chip containing magnetoresistive random access memory (MRAM) cells. The protective cover (206) includes a magnetic shielding material and at least partially encloses the memory chip. In another embodiment, the protective cover shields the memory chip without shielding at least a portion of the circuit board.

## Description

### TECHNICAL FIELD

The present invention relates generally to magnetoresistive random access memory (MRAM) devices, and more particularly to magnetic shielding of MRAM chips.

### BACKGROUND

Semiconductors are used in integrated circuits for electronic applications, including radios, televisions, cell phones, and personal computing devices, as examples. One type of semiconductor device is a semiconductor storage device, such as a dynamic random access memory (DRAM) or a flash memory, both of which use charge to store information.

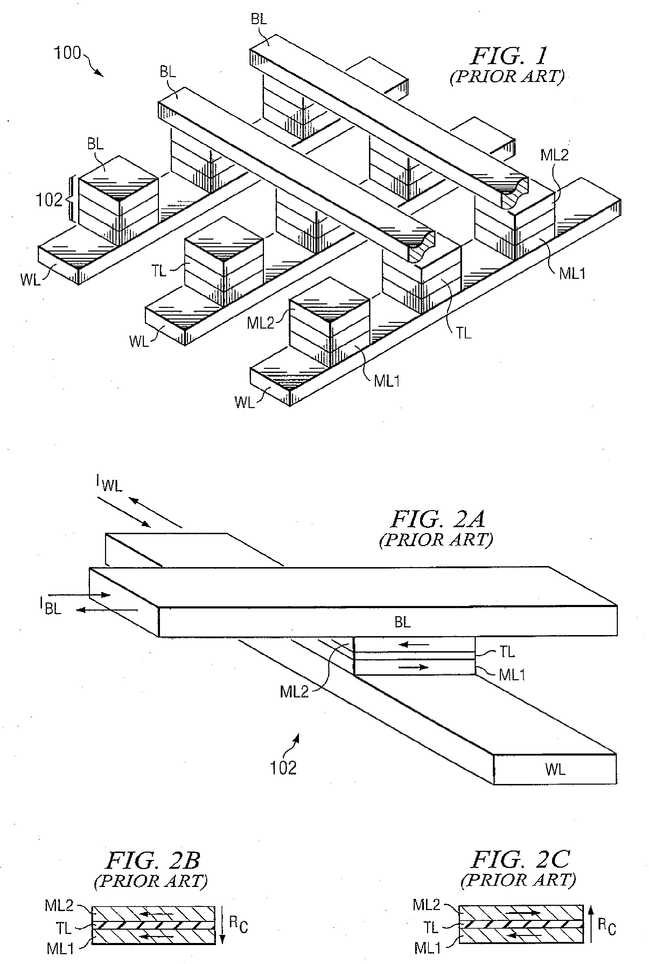

A more recent development in semiconductor memory devices involves spin electronics, which combines semiconductor technology and magnetic materials and devices. The spins of electrons, through their magnetic moments, rather than the charge of the electrons, is used to indicate the presence of a "1" or "0". One such spin electronic device is a magnetoresistive random access memory (MRAM), sometimes referred to as magnetic RAM, device 100, as shown in Figure 1, which includes conductive lines (wordlines WL and bitlines BL) positioned in a different direction, e.g., perpendicular to one another in different metal layers, the conductive lines sandwiching a magnetic stack or magnetic tunnel junction (MTJ) 102, which functions as a magnetic memory cell. Figure 1 shows a perspective view of a portion of a prior art cross-point MRAM array 100. The MRAM device 100 includes a semiconductor wafer comprising a work piece (not shown). The work piece has a first insulating layer (also not shown) deposited thereon, and a plurality of first conductive lines or wordlines WL is formed within the first insulating layer, e.g., in a first wiring level.

In a cross-point magnetic memory device 100, each memory cell or magnetic tunnel junction (MTJ) 102 is disposed over and abuts one wordline WL, as shown. The MTJ 102 of a magnetoresistive memory comprises three layers: ML1, TL and ML2. The MTJ 102 includes a first magnetic layer ML1 disposed over and abutting the wordline WL. The first magnetic layer ML1 is often referred to as a fixed layer because its magnetic orientation is fixed. A tunnel layer or tunnel barrier layer TL comprising a thin dielectric layer is formed over the fixed layer ML1. A second magnetic layer ML2 is formed over the tunnel barrier layer TL. The second magnetic layer ML2 is often referred to as a free layer because its magnetic orientation can be switched along one of two directions. The first and second magnetic layers ML1 and ML2 may comprise one or more material layers, for example.

Each MTJ 102 has a second conductive line or bitline BL disposed over and abutting the second magnetic layer ML2, as shown in Figure 1, wherein the bitline BL is positioned in a direction different from the direction of the wordline WL, e.g., the bitlines BL may be orthogonal to the wordlines WL. An array 100 of magnetic memory cells 102 comprises a plurality of wordlines WL running parallel to one another in a first direction, a plurality of bitlines BL running parallel to one another in a second direction, the second direction being different from the first direction, and a plurality of MTJ's 102 disposed between each wordline WL and bitline BL. While the bitlines BL are shown on top and the wordlines WL are shown on bottom of the array 100, alternatively, the wordlines WL may be disposed on the top of the array and the bitlines BL may be disposed on the bottom of the array, for example.

Either one of the first or second magnetic layers ML1 and ML2 may comprise a hard magnetic material (and is the fixed layer), and the other comprises a soft magnetic material (and is the free layer), although in the discussion herein, the first magnetic layer ML1 comprises the hard magnetic material, and the second magnetic layer ML2 comprises the soft magnetic material. The value of the resistance of the cell or MTJ 102 depends on the way in which the magnetic moment of the soft magnetic layer ML2 is oriented in relation to the magnetic moment of the hard magnetic layer ML1. The resistance of the magnetic memory cell 102 depends on the moment's relative alignment. The resistance R_{C} is usually lower if the magnetic layers have parallel magnetic orientations. For example, if the first and second magnetic layers ML1 and ML2 are oriented in the same direction, as shown in Figure 2B, the cell resistance Rc is low. If the first and second magnetic layers ML1 and ML2 are oriented in opposite directions, shown in Figure 2C, the cell resistance Rc is high. These two states of the cell are used to store digital information (a logic "1" or "0", high or low resistance, or vice versa).

The hard magnetic layer ML1 is usually oriented once during manufacturing. The information of the cell 102 is stored in the soft magnetic layer ML2. As shown in Figure 2A, the currents I_{WL} and I_{BL} through the wordline WL and bitline BL, respectively, provide the magnetic field that is necessary to store information in the soft magnetic layer ML2. The superimposed magnetic fields of the bitline BL and wordline WL currents have the ability to switch the magnetic moment of the soft magnetic layer ML2 and change the memory state of the cell 102.

An advantage of MRAM devices compared to traditional semiconductor memory devices such as dynamic random access memory (DRAM) devices is that MRAM devices are non-volatile. For example, a personal computer (PC) utilizing MRAM devices would not have a long "boot-up" time as with conventional PCs that utilize DRAM devices. Also, an MRAM device does not need to be powered up and has the capability of "remembering" the stored data (also referred to as a non-volatile memory). MRAM devices have the capability to provide the density of DRAM devices and the speed of static random access memory (SRAM) devices, in addition to non-volatility. Therefore, MRAM devices have the potential to replace flash memory, DRAM and SRAM devices in electronic applications where memory devices are needed in the future.

The orientation of the magnetic fields of the MRAM memory device, however, may be affected by external magnetic fields. Undesired external magnetic fields may change the orientation of the MRAM memory so that the memory may record wrong states. The sources of external magnetic fields include conducted interference via wire or cable. Other unwanted fields including electromagnetic pulses of wide dynamic range can be caused by local severe thunderstorms and improperly grounded power cable systems acting as antennas for switching transients on the power lines, or for the low-frequency power currents. Unexpected and unpredictable sources and combinations may not be completely identified and avoided. Conventionally, magnetic shielding is fabricated on/in chip packages of the MRAM chips. However, since different materials from conventional packaging materials are used, packaging is more expensive. Additionally, the shielding effect is limited.

Therefore, there is a need for a method and/or a structure for protecting the MRAM chips from external magnetic fields.

### SUMMARY OF THE INVENTION

In accordance with one aspect of the present invention, an apparatus includes an MRAM module and a protective cover. The MRAM module includes a circuit board and at least one memory chip attached to the circuit board, and the memory chip includes magnetoresistive random access memory (MRAM) cells. The protective cover is formed of magnetic shielding material and at least partially encloses the memory chip. All edges and sides of the MRAM module are preferably enclosed except the edge with contact pads. In some embodiments, openings may be formed in the protective layer. An insulating layer is preferably formed between the protective cover and conductive components on the circuit board.

In accordance with another aspect of the present invention, instead of substantially enclosing the entire MRAM module, the protective cover covers one or more MRAM chips from the topside and extends to the surface of the circuit board that the MRAM chip is attached to. However, the protective cover does not extend to edges of the circuit board. An additional protective cover can be further attached to the opposite side of the circuit board where the MRAM chips are attached.

In accordance with another aspect of the present invention, an MRAM chip is magnetically shielded with a protective cover. The MRAM chip is packaged through standard packaging processes. The protective cover is pre-formed and assembled to the MRAM chip.

In accordance with yet another aspect of the present invention, a method of manufacturing a memory device includes attaching a protective cover to a circuit board, wherein the circuit board includes a memory chip that contains MRAM cells. The protective cover at least partially encloses the memory chip after the attaching. The protective cover can be pre-formed and assembled to the circuit, or molded to the circuit board if the protective cover contains material containing magnetic shielding particles.

An advantageous feature of the present invention is that no customized MRAM chip packaging is required and thus cost is lowered. Another advantageous feature of the present invention is that the shielding effectiveness can be adjusted according to the work environment the MRAM chips are subjected to.

### BRIEF DESCRIPTION OF THE DRAWINGS

For a more complete understanding of the present invention, and the advantages thereof, reference is now made to the following descriptions taken in conjunction with the accompanying drawings, in which:

Figure 1 illustrates a perspective view of a prior art MRAM device having magnetic stack memory cells arranged in an array, with wordlines and bitlines disposed below and above each memory cell for accessing the memory cells;

Figure 2A through 2C illustrate a single MRAM cell and the currents used to program the cell;

Figure 3 illustrates a perspective view of an MRAM module partially enclosed by a protective cover formed of magnetic shielding material;

Figure 4 illustrates a cross sectional view of the embodiment shown in Figure 3;

Figure 5 illustrates a cross sectional view of an MRAM module partially enclosed by a protective cover, wherein an opening is formed in the protective cover for a socket;

Figure 6 illustrates a perspective view of an MRAM chip covered by a protective cover from the topside;

Figure 7A illustrates a protective cover pre-assembled to a memory chip;

Figure 7B illustrates a cross sectional view of the embodiment shown in Figure 6;

Figures 8A and 8B illustrate an MRAM chip magnetically shielded by a protective cover after the MRAM chip is packaged, where pins are formed on sides of the MRAM chip; and

Figures 9A, 9B and 9C illustrate an MRAM chip magnetically shielded by a protective cover after the MRAM chip is packaged, where pins are formed along bottom corners of the MRAM chip.

### DETAILED DESCRIPTION OF ILLUSTRATIVE EMBODIMENTS

The making and using of the presently preferred embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

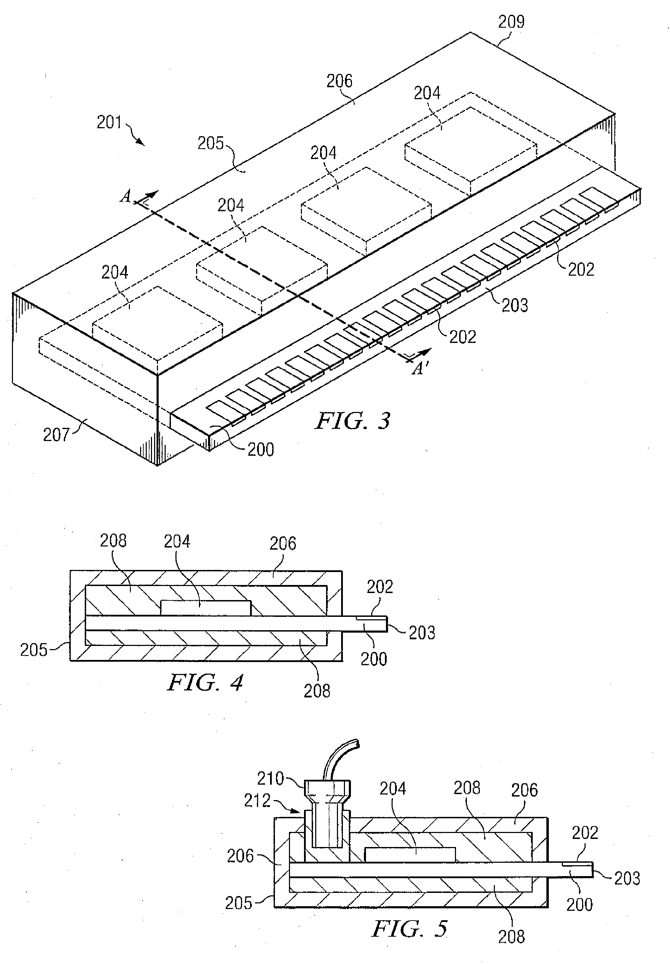

Figure 3 illustrates a preferred embodiment of the present invention. Memories are often used in the form of memory modules. Throughout the description, the term "memory module" is used to refer to any circuit board that has at least one memory chip, even if the memory chip is not a main component. Thus, besides memory chips 204, a memory module may also contain other circuit components. A memory module 201 includes MRAM chips 204 attached to the topside of a circuit board 200, which typically has four ends 203, 205, 207 and 209. The MRAM chips 204 can be packaged using standard packaging processes with no or very limited magnetic shielding. Contacts pads 202 of the memory modules 201 are typically the only components that need to be exposed externally. Typically, all contact pads of the memory module are formed at one end, although other ends may also have contact pads.

Standard memory chips and memory modules are typically not magnetically shielded. This posts a problem for MRAM chips and may cause states of MRAM cells to be wrongfully changed. A protective cover 206, sometimes referred to as a protective casing, is attached to the memory module 201. In the preferred embodiment, the protective cover 206 is made of materials with high permeability such as Mu-metal. As known in the art, Mu-metal is nickel-iron alloy generally used for magnetic shielding. One typical Mu-metal includes about 5 percent copper, 2 percent chromium, 77 percent nickel, and 16 percent iron. Another well-known Mu-metal alloy comprises about 77 percent nickel, 15 percent iron, and other materials such as copper and molybdenum.

In another embodiment of the present invention, the protective cover 206 may have a composite structure including two or more layers. Each of the layers serves one purpose. When combined, the composite structure has an improved magnetic shielding effect. For example, a protective cover 206 suitable for both high and low frequency shielding has a first layer formed of Mu-metal, and a second layer formed of materials such as copper, galvanized steel, aluminum, and some specially treated rubber and plastics. The second layer shields the memory module from high frequencies through its high conductivity characteristics.

In yet other embodiments, the composite protective layer 206 includes a first layer with higher permeability and a second layer with a higher saturation value, wherein the second layer is used to extend the limiting point so that very strong magnetic fields can be shielded. The protective cover preferably reduces the magnitude of the magnetic field at the MRAM chip by about 20 percent, more preferably by about 50 percent, and even more preferably by about 80 percent. Since magnetic shield effectiveness is generally proportional to the thickness of the protective cover 206, particularly at low frequencies, a thicker protective cover is preferred. It is to be appreciated that the appropriate material and thickness depend on the magnitude and characteristics of the magnetic field the memory module is subjected to, and can be found out through measurements.

In the preferred embodiment, the protective cover 206 can be pre-formed and attached to the memory module. Preferably, a shielding material with high permeability, such as a Mu-metal sheet, is bent and shaped to a desired shape, and attached to the memory module by commonly used methods such as crimping, soldering, screwing, and the like. An advantage of this embodiment is that the attenuation, which measures the ratio of the magnetic field being shielded, can be adjusted easily according to the work environment of the MRAM chips. If one protective cover does not provide adequate shielding by reducing magnetic fields to an acceptable level, it can be replaced with another one with better shielding effects. If magnetic shielding material is integrated into the MRAM chip package, changing packaging processes is much more costly.

Alternatively, the protective cover 206 can be molded to the memory module so that the protective cover 206 and the memory module become an integrated unit. The molding material is preferably a magnetic shielding material, such as materials containing magnetic shielding particles. The molding material may also contain materials such as epoxy, plastic, rubber, glue, and the like, and the resulting mixture will have a good permeability.

Since magnetic shielding material is typically electrically conductive, a nonconductive layer is preferably formed to insulate the protective cover 206 and other conductive components on the memory module 201. Figure 4 illustrates a cross sectional view of the preferred embodiment along line A-A' in Figure 3. An insulating layer 208 electrically insulates the chip 204, the protective cover 206 and underlying materials. The insulating layer 208 preferably has good heat conductivity for the MRAM chips 204 to dissipate heat. The insulating layer 208 may be formed of dielectric materials or simply air if the protective layer has enough strength to maintain its shape.

Although a protective cover 206 provides better magnetic shielding when the ends 205, 207, 209, and top and bottom sides are wrapped inside, sometimes openings have to be formed. For example, sockets are commonly formed at the end 205 and/or the topside for incoming or outgoing signals. Contact pads may also be distributed along more than one edge so that these edges must also be exposed through the protective cover. Figure 5 illustrates such an example, where a socket 210 is attached to the circuit board 200. An opening 212 is therefore formed in the protective cover 206. With openings, the protective cover 206 still provides magnetic shielding although the shielding effect is reduced.

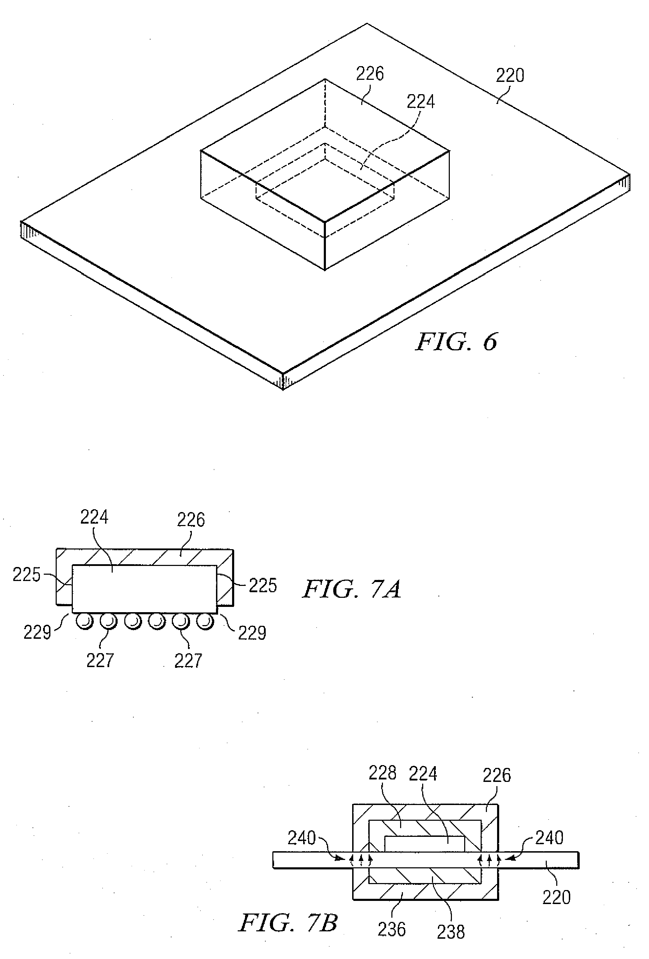

Enclosing the entire board is not always convenient. A circuit board may have a limited number of memory chips, and other components cannot be magnetically shielded. Therefore, instead of enclosing most of the board, as illustrated in Figure 3, only the memory portion is protected from the magnetic field. Figure 6 illustrates an embodiment with MRAM chip(s) 224 shielded locally on a circuit board 220. A memory chip 224 is attached to the circuit board 220, preferably with an insulating layer 228 (please refer to Figure 7B, which is a cross sectional view of Figure 6), electrically insulating the pins of the MRAM chip 224 and other conductive components. A protective cover 226 is then formed covering the top of the MRAM chip 224 and extending down to the circuit board 220 so that the sidewalls of the memory chip 224 are also shielded.

In the preferred embodiment, the protective cover 226 is formed by molding or otherwise adhering a magnetic material on the memory chip 224. Similar to the molding of a memory module as shown in the previously discussed embodiment, the molding material includes magnetic shielding materials, such as materials containing magnetic shielding particles, and other materials such as epoxy, plastic, rubber, glue, etc. Both the insulating layer 228 and the protective cover 226 preferably have good heat conductivity. In alternative embodiments, the protective cover 226 can be pre-made and assembled to the circuit board 220, and the protective cover 226 may be formed of sheet metals such as alloys with high permeability. In yet other embodiments, if more than one MRAM chips are closely spaced, one protective cover is preferably used to shield all closely spaced MRAM chips.

Figure 7A illustrates a protective cover 226 pre-assembled to a memory chip 224. The contacts 227 may be contact pins formed at the bottom of the chip 224. However, in embodiments where memory chips are to be flip-packaged directly to a circuit board, contacts 227 can also be solder balls. A protective cover 226 covers the top of the memory chip 224 and wraps around to the sides 225, preferably as close to the bottom corners 229 as possible. The structure shown in Figure 7A can then be attached to a circuit board, and the resulting structure is shown in Figure 6.

Figure 7B illustrates a cross sectional view of the embodiment shown in Figure 6. Preferably, a bottom protective cover 236 is formed on the bottom side of the board 220. With two protective layers 226 and 236 closely located, the magnetic flux going into one of the protective cover 226 and the bottom cover 236 is likely to travel to the other part, and magnetic flux channels 240, which are symbolized by arrows, will exist between the two protective covers. If no low resistive path is provided through the board 220, the shielding effect is reduced. Therefore, the flux channels 240 with low permeability are preferred to confine magnetic fields. This can be achieved by forming low permeability plugs, which physically connect the protective cover 226 and the bottom cover 236, through the circuit board 220. As the bottom side of the circuit board 220 typically contains solder, an insulating layer 238 is preferably formed.

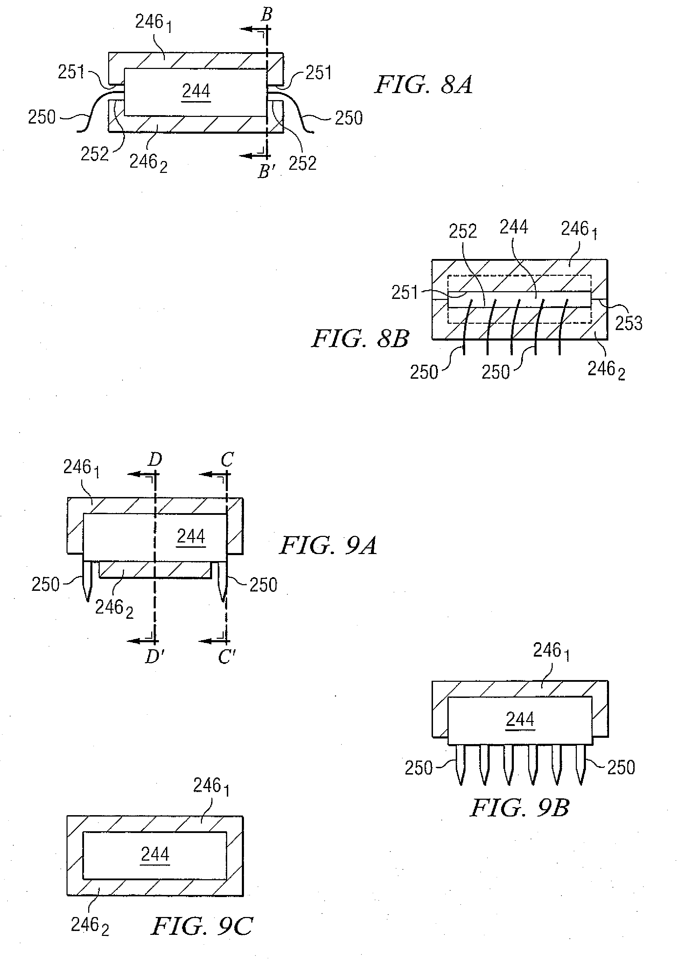

In each of the embodiments described above, the magnetic shielding was described as surrounding the MRAM chips after they are attached to circuit boards. While this configuration minimizes any effects of magnetic radiation, it may be inconvenient for manufacturing purposes. Therefore, another embodiment of the present invention envisions a magnetic shielding that covers MRAM chips, as illustrated in Figures 8A and 8B.

In Figure 8A, an MRAM chip 244 is packaged through standard packing processes and thus is not magnetically shielded. In the preferred embodiments, pins 250 are formed on sides of the MRAM chip 244. A top protective cover 246₁ and a bottom protective cover 246₂ are pre-formed and assembled to the MRAM chip to cover top and bottom surfaces of the MRAM chip 244, respectively. The top and bottom protective covers 246₁ and 246₂ preferably wrap around the corners of the MRAM chip 244. Since protective covers 246₁ and 246₂ are typically conductive, the edges 251 and 252 of the respective top and bottom protective covers are spaced apart, allowing pins 250 to extend out without touching the protective covers. The distance between edges 251 and 252 is preferably small to improve the shielding effect.

If among four edges of the MRAM chips, one or more sides have no pins, the top and bottom protective covers 246₁, 246₂ can be in contact physically on these sides. Figure 8B illustrates a cross sectional view of Figure 8A along line B-B', wherein two sides of the chip do not have pins. After assembling, the top and bottom protective covers 246₁ and 246₂ are integrated along line 253. Therefore, magnetic lines going into one of the protective covers will be routed to the other one and out of the protective cover, and thus the MRAM chip 244 is shielded. In alternative embodiments as shown in Figures 9A, 9B and 9C, pins 250 are formed along bottom corners of the chip 244, and thus the bottom protective cover 246₂ cannot wrap around the corners of the MRAM chip 244. Figure 9B illustrates a cross sectional view of Figure 9A along lines C-C'. The top and bottom protective covers 246₁ and 246₂ can still join on the sides where there is no pin, as shown in Figure 9C, which is a cross sectional view of Figure 9A along line D-D'.

In other embodiments, the protective 246 is an integrated unit, instead of being formed of two portions, and better magnetic shielding effect can be achieved. However, some shaping may be required after the protective cover is attached to the MRAM chip 244.

The embodiment shown in Figures 8a and 8b does not need an insulating layer since there is typically no conductive component on the top and bottom surfaces. There is less concern about thermal issues, also due to lack of an insulating layer.

The preferred embodiments of the present invention have some advantageous features. Firstly, the magnetic shielding is not fabricated along with the MRAM chip package, and standard packaging processes can be performed. This avoids expensive customized packaging. Secondly, since the magnetic shielding is assembled after the MRAM chips are attached to the MRAM modules, appropriate magnetic shielding can be applied according to the strength of the external magnetic field. For example, at locations where high magnetic fields are present, thicker protective covers with composite structures and high permeability can be used. In locations where magnetic fields are low, thin and less expensive protective covers can be used. Thirdly, the preferred embodiments of the present invention can be easily formed and assembled.

Although the present invention and its advantages have been described in detail, it should be understood that various changes, substitutions and alterations can be made herein without departing from the spirit and scope of the invention as defined by the appended claims. Moreover, the scope of the present application is not intended to be limited to the particular embodiments of the process, machine, manufacture, and composition of matter, means, methods and steps described in the specification. As one of ordinary skill in the art will readily appreciate from the disclosure of the present invention, processes, machines, manufacture, compositions of matter, means, methods, or steps, presently existing or later to be developed, that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. An apparatus comprising:
a memory module comprising:
a circuit board; and
a memory chip attached to the circuit board, the memory chip comprising magnetoresistive random access memory (MRAM) cells; and
a protective cover at least partially enclosing the memory chip, the protective cover comprising magnetic shielding material.

2. The apparatus of claim 1 wherein the protective cover reduces a magnitude of magnetic fields at the memory chip by about 20 percent relative to the memory chip not shielded by the protective cover.

3. The apparatus of claim 2 wherein the protective cover reduces a magnitude of magnetic fields at the memory chip by about 50 percent relative to the memory chip not shielded by the protective cover.

4. The apparatus of claim 1 wherein the protective cover comprises Mu-metal.

5. The apparatus of claim 1 wherein the protective cover comprises about 77 percent nickel, and about 15 to 16 percent iron.

6. The apparatus of claim 1 wherein the protective cover comprises material containing magnetic shielding particles.

7. The apparatus of claim 1 wherein the protective cover has a composite structure comprising more than one layer.

8. The apparatus of claim 1 further comprising an electrical insulating layer between the protective cover and at least one of the memory chip and/or the circuit board.

9. The apparatus of claim 8 wherein the electrical insulating layer comprises air.

10. The apparatus of claim 1 wherein the circuit board of the MRAM module has a first end having contact pads, a second end, a third end, a fourth end, a first side and a second side opposite the first side, wherein the protective cover is open at the first end.

11. The apparatus of claim 10 wherein the protective cover at least partially covers the first and the second sides and wraps around the second, third and fourth ends.

12. The apparatus of claim 11 wherein the protective cover has openings in at least one of the second, third, or fourth ends or the first or second sides.

13. The apparatus of claim 10 wherein the protective cover does not extend to at least one of the first, second, third or fourth ends.

14. The apparatus of claim 13 further comprising an additional protective cover on the second side of the circuit board, the additional protective cover being formed of a magnetic shielding material.

15. The apparatus of claim 14 wherein the additional protective cover is coupled to the protective cover through the magnetic shielding material.

16. The apparatus of claim 14 further comprising an additional insulating layer between the additional protective cover and the second side of the circuit board.

17. The apparatus of claim 13 further comprising an extra protective cover at least partially enclosing an additional memory chip, the extra protective cover comprising a magnetic shielding material.

18. An apparatus comprising:
a semiconductor chip with MRAM cells formed therein; and
a protective cover formed over at least two surfaces of the semiconductor chip, the protective cover comprising a magnetic shielding material.

19. The apparatus of claim 18 wherein at least one edge of the protective cover wraps around a corner of the semiconductor chip.

20. The apparatus of claim 18 wherein the protective cover comprises a top portion and a bottom portion.

21. A method of manufacturing a memory device, the method comprising attaching a protective cover to a circuit board, wherein the circuit board has a memory chip comprising MRAM cells, wherein the protective cover at least partially encloses the memory chip after the attaching.

22. The method of claim 21 wherein the attaching comprises crimping a portion of the protective cover.

23. The method of claim 21 wherein the attaching comprises molding the protective cover onto the circuit board.

24. The method of claim 21 wherein the attaching comprises bending and shaping the protective cover.
